# EUROPÄISCHE PATENTSCHRIFT

(11) **EP 0 812 431 B1**
(45) Veröffentlichungstag und Bekanntmachung des Hinweises auf die Patenterteilung: **13.01.1999**
(21) Anmeldenummer: 96904710.9
(22) Anmeldetag: 26.02.1996
(51) Int. Cl.: G02F 1/015, H01S 3/19, H01S 3/25

(54) **INTEGRIERT OPTISCHER WELLENLEITER MIT EINER EINEN STEUERBAREN KOMPLEXEN BRECHUNGSINDEX AUFWEISENDEN WELLENLEITENDEN SCHICHT**
INTEGRATED OPTICAL FIBRE WITH AN OPTICAL LAYER HAVING A CONTROLLABLE COMPLEX REFRACTION INDEX
FIBRE OPTIQUE INTEGREE A COUCHE OPTIQUE A INDICE DE REFRACTION COMPLEXE REGULABLE

(30) Priorität: 28.02.1995 DE 19506960
(43) Veröffentlichungstag der Anmeldung: 17.12.1997
(73) Patentinhaber: SIEMENS AKTIENGESELLSCHAFT, 80333 München (DE)
(72) Erfinder: SCHIMPE, Robert, D-85521 Riemerling (DE)
(86) Internationale Anmeldenummer: DE9600317
(87) Internationale Veröffentlichungsnummer: WO9627146

(56) Entgegenhaltungen:
- EP-A- 0 420 749
- EP-A- 0 447 096
- EP-A- 0 457 571
- EP-A- 0 612 129
- GB-A- 2 207 283

## Beschreibung

Die Erfindung betrifft ein integriert-optisches Element auf einem Substrat aus InP nach dem Oberbegriff des Patentanspruchs 1.

Ein integriert-optisches Element der genannten Art ist aus dem Dokument GB-A-2 207 283 bekannt, in welchem fünf verschiedene Beispiele integriert-optischer Elemente auf einem Substrat aus InP beschrieben sind.

Allen diesen Beispielen ist gemeinsam, daß die an die wellenleitende Schicht grenzenden Schichten aus ternärem Material einer derartigen Zusammensetzung bestehen, daß diese Schichten die gleiche Kristallgitterkonstante wie das InP des Substrats aufweisen.

Bei zwei Beispielen besteht die wellenleitende Schicht aus drei aneinandergrenzenden dünnen Schichten, einer zentralen Schicht und zwei äußeren Schichten, an welche die an die wellenleitende Schicht grenzenden Schichten angrenzen. Diese äußeren dünnen Schichten weisen jeweils eine Kristallgitterkonstante auf, die in Richtung auf die zentrale dünne Schicht graduell von der relativ kleineren Kristallgitterkonstanten der an die wellenleitende Schicht grenzenden Schichten auf die relativ größere Kristallgitterkonstante der zentralen dünnen Schicht zunimmt.

Bei einem der beiden letztgenannten Beispiele ist die relativ größere Kristallgitterkonstante der zentralen dünnen Schicht nur um 0,5% größer als die Kristallgitterkonstante des InP des Substrats.

Ein integriert-optisches Element auf einem Substrat aus InP, bestehend aus
- einer wellenleitenden Schicht eines bestimmten komplexen Brechungsindexes und
- zwei je einen reellen Brechungsindex aufweisenden Schichten aus Halbleitermaterial, zwischen denen die wellenleitende Schicht angeordnet ist, die an die wellenleitende Schicht grenzen und von denen sich eine zwischen der wellenleitenden Schicht und dem Substrat befindet, wobei
- der komplexe Brechungsindex der wellenleitenden Schicht durch elektrische Ladungsträger steuerbar ist und einen Realteil aufweist, der jeweils größer als der reelle Brechungsindex der beiden an die wellenleitende Schicht angrenzenden Schichten ist, wobei
- in die wellenleitende Schicht Licht einer bestimmten Wellenlänge einkoppelbar und das eingekoppelte Licht im wesentlichen in der wellenleitenden Schicht geführt ist, und wobei
- eine Einrichtung zur Steuerung des komplexen Brechungsindexes in der wellenleitenden Schicht vorgesehen ist, so daß die Intensität und/oder Phase des in der wellenleitenden Schicht geführten Lichts veränderbar ist,
geht aus folgenden Dokumenten hervor:
a) K. Magari et al.: "Polarization-Insensitive Optical Amplifier with Tensile-Strained-Barriere MQW-Structure", IEEE J. of Quantum Electr., Vol. QE-30, No. 3 (1994) S. 695-702,
b) M.A. Newkirk et al.: "1,5 µm Multi-Quantum-Well Semiconductor Optical Amplifier with Tensile and Compressively Strained Wells for Polarization Independent Gain", IEEE Photon. Technol. Lett., Vol. PTL-4, No. 4, 1993, S. 406-408,
c) P.J.A. Thijs et al.: "Progress in Long-Wavelength Strained-Layer InGaAs(P) Quantum-Well Semiconduktor Lasers and Amplifiers",IEEE J. of Quantum Electron., Vol. QE-30, No. 2 (1994), S.477 -499,
d) Ch. Holtmann et al.:"Polarization Insensitive Bulk Ridge-type Semiconductor Optical Amplifiers at 1,3 µm Wavelength", Yokohama, Japan, 4.-6. July 1993, Paper Sub 2-1, S. 8-11 (1993)
e) L.F. Tiemeijer et al.: "High Performance 1300 nm Polarisation Insensitive Laser Amplifiers Employing both Tensile and Compressively Strained Quantum Wells in a Single Active Layer" Proc. Europ. Conf. Opt. Commun. '92 (ECOC'92), Pt. 3,Berlin, 1992, S.911 - 914.

Jedes der in diesen Dokumenten a) bis e) beschriebenen Elemente bildet einen Wellenleiter in Form eines polarisationsunabhängigen optischen Verstärkers.

Bei dem im Dokument a) beschriebenen Verstärker weist die wellenleitende Schicht Quantumwell-Schichten in Form von schwach zugverspannten Potentialtöpfen oder Potentialbarrieren auf. Schwach zugverspannte Töpfe benötigen relativ hohen Strom wegen "Valence band mixing". Quantumwells mit zugverspannten Barrieren erfordern große Dicken, die wegen der Verspannung schwierig herzustellen sind und die Strukturen in den Bereich gewöhnlicher Schichtstrukturen ohne Quantisierungseffekt rücken.

Bei den in den Dokumenten b) und c) beschriebenen Wellenleitern weist die wellenleitende Schicht Quantumwell-Schichten in Form von abwechselnd zug- und druckverspannten Patentialtöpfen auf. Solche Quantumwell-Schichten sind erfolgreich bei optischen Verstärkern für 1,3 µm Wellenlänge realisiert worden.

Der im Dokument d) beschriebene Wellenleiter ist ein Rippenwellenleiter, dessen wellenleitende Schicht homogen aus In-GaAsP mit einer Gap-Wellenlänge von 1,3 µm und einer Dicke zwischen 150 nm und 400 nm besteht.

Der aus Dokument e) bekannte Wellenleiter ist ein Burried Heterostruktur-Wellenleiter mit polarisationsunabhängiger Wellenführung.

Aus dem Dokument EP-A-612 129 ist ein integriert-optisches Element auf einem n-dotierten Substrat aus GaAs bekannt, bei dem eine wellenleitenden Schicht zwischen zwei Schichten aus Halbleitermaterial angeordnet ist, die an die wellenleitende Schicht grenzen und von denen sich eine Schicht zwischen der wellenleitenden Schicht und dem Substrat befindet und n-dotiert ist, während die andere Schicht p-dotiert ist.

Generell weist bei diesem Element die wellenleitende Schicht eine Kristallgitterkonstante auf, die kleiner als eine bestimmte Kristallgitterkonstante des GaAs des Substrats ist.

Bei einem Ausführungsbeispiel dieses Elements liegt die Besonderheit vor, daß jede der beiden an die wellenleitende Schicht grenzenden Schichten, von denen sich eine Schicht zwischen der wellenleitenden Schicht und dem Substrat befindet, jeweils eine Kristallgitterkonstante aufweisen, die sowohl größer als die Kristallgitterkonstante des GaAs des Substrats als auch größer als die Kristallgitterkonstanten der wellenleitenden Schicht ist, und daß zwischen der sich zwischen der wellenleitenden Schicht und dem Substrat befindenden und an die wellenleitende Schicht grenzenden einen Schicht und dem Substrat eine an das Substrat grenzende und in diesem Dokument als Pufferschicht bezeichnete Trägerschicht aus Halbleitermaterial mit einer Kristallgitterkonstanten, die am Substrat gleich der bestimmten Kristallgitterkonstanten des GaAs des Substrats ist und vom Substrat in Richtung auf die an die wellenleitende Schicht grenzende eine Schicht auf die größere Kristallgitterkonstante dieser einen Schicht zunimmt, angeordnet ist. Die größere Kristallgitterkonstante ist um etwa 1% größer als die Kristallgitterkonstante des Substrats.

Die Trägerschicht ist von der an die wellenleitende Schicht grenzenden einen Schicht durch einen in diesem Dokument als Superlattice layer bezeichneten Schichtenstapel getrennt, der aus zwei Arten sehr dünner Schichten aus Halbleitermaterial unterschiedlicher Bandlücke besteht. Die Kristallgitterkonstante des Schichtenstapels ist der des am nächsten liegenden Teils der Trägerschicht angepaßt.

Der im Anspruch 1 angegebenen Erfindung liegt die Aufgabe zugrunde, ein integriert-optisches Element bereitzustellen, das eine polarisationsunabhängige Wellenführung bei einer Wellenlänge von 1,55 µm ermöglicht.

Ein besonderer Vorteil des erfindungsgemäßen Elements liegt darin, daß es bei der Wellenlänge 1,55 µm als polarisationsunabhängiger optischer Verstärker und darüber hinaus als polarisationsunabhängiger optischer Modulator oder Richtkoppler oder auch als polarisationsunabhängiges Filter einsetzbar ist.

Als polarisationsunabhängiger optischer Verstärker bei einer Wellenlänge von 1,55 µm kann das erfindungsgemäße integriert-optische Element vorteilhaft eingesetzt werden als sendeseitiger Boosterverstärker, als Zwischenverstärker in einer Übertragungsstrecke und als Empfängervorverstärker.

In diesem Zusammenhang sei darauf hingewiesen, daß bei den aus Dokument b) und c) bekannten und erfolgreich für 1,3 µm Wellenlänge realisierten Wellenleitern mit zug- und druckverspannten Quantumwell-Schichten bei der Wellenlänge 1,55 µm nur noch die Ausläufer des Verstärkungsspektrums genutzt werden, da die Zugverspannung die Wellenlänge maximaler Verstärkung zu kürzeren Wellenlängen verschiebt, bei etwa 1,50 µm liegen.

Bevorzugte und vorteilhafte Ausgestaltungen des erfindungsgemäßen Elements gehen aus den Unteransprüchen hervor. Insbesondere geht daraus hervor, daß das erfindungsgemäße Element vorteilhafterweise auch als Rippenwellenleiter realisierbar ist, insbesondere mit einer Diodenstruktur, deren Herstellverfahren eine hohe Zuverlässigkeit und Kompatibilität mit bereits benutzten Herstellprozessen für Halbleiterlaserdioden bieten.

Die Erfindung wird in der nachfolgenden Beschreibung anhand der Figuren beispielhaft näher erläutert. Es zeigen:
- Figur 1: in perspektivischer Darstellung und ausschnitthaft ein erstes Ausführungsbeispiel eines erfindungsgemäßen Elements in Form eines Rippenwellenleiters mit einer Rippe konstanter Breite und
- Figur 2: in der gleichen Darstellung ein zweites Ausführungsbeispiel eines erfindungsgemäßen Elements in Form eines Rippenwellenleiters mit taperförmig sich verbreiternder Rippe.

Die Figuren sind schematisch und nicht maßstäblich.

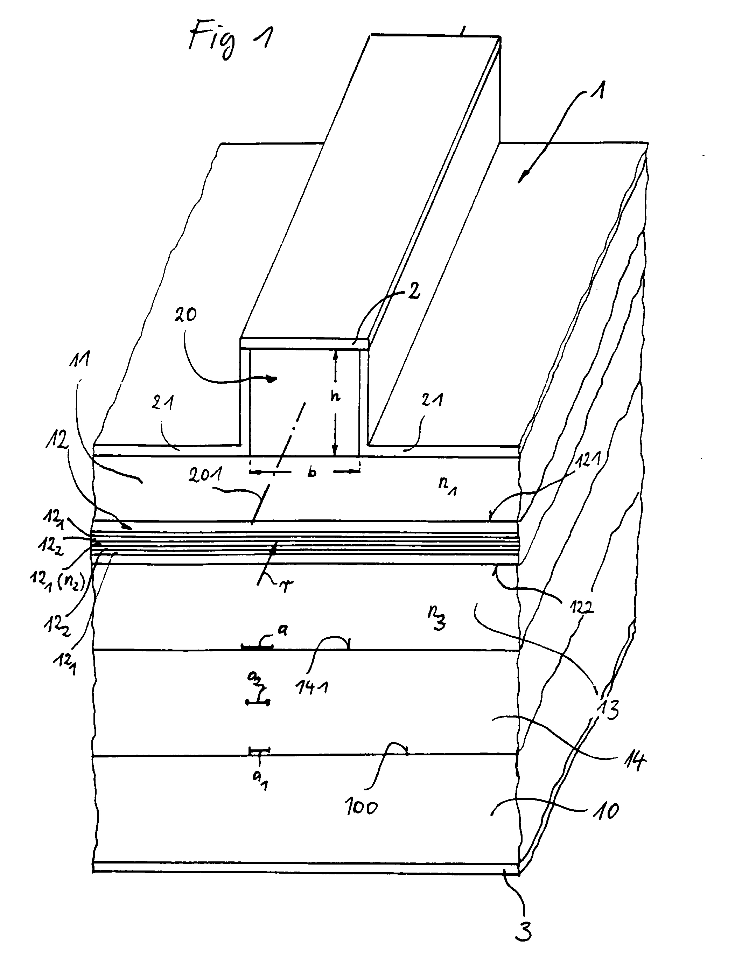

Bei dem in der Figur 1 dargestellten integriert-optischen Rippenwellenleiter ist auf einer Oberfläche 100 eines Substrats 10 aus Halbleitermaterial aus InP eines Leitfähigkeitstyps, beispielsweise n-dotiertes InP, eine Trägerschicht 14 aus Halbleitermaterial des gleichen Leitfähigkeitstyps mit einer von der Oberfläche 100 des Substrats 10 in Richtung zu der von diese Oberfläche 100 abgekehrten Oberfläche 141 der Trägerschicht 14 variierenden Kristallgitterkonstante a₂ aufgebracht.

Diese variierende Kristallgitterkonstante a₂ ist an oder nahe der Oberfläche 100 des Substrats 10 gleich der bestimmten Kristallgitterkonstanten a₁ des InP und nimmt in Richtung zu der vom Substrat 10 abgekehrten Oberfläche 141 der Trägerschicht 14 auf eine Kristallgitterkonstante a zu, die um weniger als 1 %, vorzugsweise um im wesentlichen 0,5 % größer als die Kristallgitterkonstante a₁ von InP ist. Diese größere Kristallgitterkonstante a ist an der vom Substrat 10 abgekehrten Oberfläche 141 der Trägerschicht 14 vorhanden.

Die Trägerschicht 14 kann bezüglich einer später beschriebenen bevorzugten Ausführungsform des erfindungsgemäßen Elements mit einer Schicht 13 aus InAsP vorteilhafterweise aus InAsP und InP bestehen, wobei der von der Oberfläche 100 des Substrats 10 in Richtung zur Oberfläche 141 der Trägerschicht 14 vom binären InP zum ternären InAsP übergeht.

Beispielsweise nimmt von der Oberfläche 100 des Substrats 10 in Richtung zur Oberfläche 141 der Trägerschicht 14 der Gehalt von InP graduell von 100 % auf 0 % ab und der des InAsP graduell von 0% auf 100 % zu.

Auf der vom Substrat 10 abgekehrten Oberfläche 141 der Trägerschicht 14 ist eine erste Schicht 13 aus Halbleitermaterial des gleichen Leitfähigkeitstyps wie dem des Substrats 10 und der Trägerschicht 14 aufgebracht, vorzugsweise epitaktisch aufgewachsen, welche erfindungsgemäß die gleiche größere Kristallgitterkonstante a aufweist, wie sie an der vom Substrat 10 abgekehrten Oberfläche 141 der Trägerschicht 14 vorhanden ist.

Auf der vom Substrat 10 und der Trägerschicht 14 abgekehrten Oberfläche 131 der ersten Schicht 13 ist die wellenleitende Schicht 12 mit dem bestimmten, durch elektrische Ladungsträger steuerbaren komplexen Brechungsindex aufgebracht, beispielsweise epitaktisch aufgewachsen. Diese wellenleitende Schicht 12 weist eine der Oberfläche 131 der Schicht 13 zugekehrte Flachseite 122 und eine von der Schicht 13 abgekehrte Flachseite 121 auf. Darüberhinaus weist die wellenleitende Schicht erfindungsgemäß die gleiche größere Kristallgitterkonstante a wie die Schicht 13 auf.

Auf der von der Schicht 13 abgekehrten Flachseite 121 der wellenleitenden Schicht 12 ist eine Schicht 11 aus Halbleitermaterial mit einer im Vergleich zum Leitfähigkeitstyp des Substrat 10 entgegengesetzten Leitfähigkeitstyps aufgebracht, welche erfindungsgemäß die gleiche größere Kristallgitterkonstante a wie die Schicht 13 und die wellenleitende Schicht 12 aufweist.

Die Schicht 13 bildet das an die dem Substrat 10 zugekehrte Flachseite 122 der wellenleitenden Schicht 12 angrenzende Halbleitermaterial der erfindungsgemäß größeren Kristallgitterkonstante a und die Schicht 11 das an die vom Substrat 10 abgekehrte Flachseite 121 der wellenleitenden Schicht 12 angrenzende Halbleitermaterial der erfindungsgemäß größeren Kristallgitterkonstanten a.

Auf der von der wellenleitenden Schicht 12 abgekehrten Oberfläche 111 der Schicht 11 ist eine Rippe 20 aus einem Halbleitermaterial des gleichen Leitfähigkeitstyps wie die Schicht 11 aufgebracht. Bei n-dotiertem Substrat 10 sind die Schicht 11 und die Rippe 20 p-dotiert.

Die Rippe 20 ist auf der vom Substrat 10 abgekehrten Flachseite 121 der wellenleitenden Schicht 12 angeordnet, was aber nicht bedeutet, daß die Rippe 20 die wellenleitende Schicht 12 kontaktieren muß. Beim dargestellten Beispiel ist die Rippe 20 durch die Schicht 11 von der wellenleitenden Schicht 12 getrennt.

Der Realteil n₂ des steuerbaren komplexen Brechungsindex der wellenleitenden Schicht 12 ist größer als ein reeller Brechungsindex n₁ der Schicht 11 und größer als ein reeller Brechungsindex n₃ der Schicht 13. Der reelle Brechungsindex n₁ der Schicht 11 kann gleich dem reellen Brechungsindex n₃ der Schicht 13 sein. Die Schichten 11 und 13 können wie die wellenleitende Schicht 12 einen komplexen Brechungsindex aufweisen. Ihr reeller Brechungsindex ist dann der Realteil des komplexen Brechungsindex dieser Schichten 11 und 13.

In die wellenleitende Schicht 12 ist beispielsweise durch die dem Betrachter der Figur 1 zugekehrte Stirnfläche 123 der wellenleitenden Schicht 12, auf die der Pfeil r zeigt, Licht einkoppelbar, das in der wellenleitenden Schicht 12 im wesentlichen zwischen deren Flachseiten 121 und 122 geführt wird.

Der komplexe Brechungsindex der wellenleitenden Schicht 12 ist durch eine Einrichtung zur Steuerung dieses Brechungsindex durch Ladungsträger steuerbar, so daß die Intensität I und/oder die Phase Φ des in der wellenleitenden Schicht 12 geführten Lichts veränderbar ist/sind.

Diese Einrichtung zur Steuerung des komplexen Brechungsindex weist einen auf der vom Substrat 10 und der wellenleitenden Schicht 12 abgekehrten Oberfläche 202 der Rippe 20 angeordneten elektrischen Kontakt 2 und einen auf der von der Rippe 20 und der wellenleitenden Schicht 12 abgekehrten Unterseite 101 des Substrats 10 angeordneten elektrischen Kontakt 3 auf, zwischen denen eine elektrische Steuerspannung zur Steuerung des komplexen Brechungsindex n₂ anlegbar ist.

Die Rippe 20 weist eine zu der Flachseite 121 parallele und eine Ausbreitungsrichtung des in der wellenleitenden Schicht geführten Lichts bestimmende Längsachse 201 und eine bestimmte Breite b auf, wobei die Rippe 20 eine im wesentlichen auf deren Breite b begrenzte Wellenführung des in der wellenleitenden Schicht 12 geführten Lichts bewirkt. Eine von der Oberfläche 111 der Schicht 11 gemessene Höhe der Rippe 20 ist mit h bezeichnet.

Der Pfeil r ist in Richtung der Längsachse 201 der Rippe 20 ausgerichtet und gibt, wie schon erwähnt, die Ausbreitungsrichtung des in die wellenleitende Schicht 12 eingekoppelten und dieser Schicht 12 geführten Lichts an.

Die Oberfläche 111 der Schicht 11 und die Seitenflächen 203 und 204 der Rippe 20 sind mit einer Schicht 21 aus elektrisch isolierendem Material bedeckt, auf die elektrische Zuleitungen zum Kontakt 2 auf der Rippe 20 aufgebracht werden können.

Die Trägerschicht oder das Superlattice 14 hat die Aufgabe, die Gitterkonstante von der Gitterkonstanten a₁ des InP des Substrats 10 auf die größere Gitterkonstante a "aufzuweiten", die um weniger als 1 %, vorzugsweise im wesentlichen 0,5 %, größer als die Gitterkonstante a₁ des InP ist. Da diese größere Gitterkonstante a an der vom Substrat 10 abgekehrten Oberfläche 141 der Trägerschicht 14 vorhanden ist, können die Schicht 13, die wellenleitende Schicht 12 und die Schicht 11 aus Materialien bestehen, welche im wesentlichen die gleiche größere Gitterkonstante a aufweisen. Dadurch ist es möglich, für die wellenleitende Schicht 12 ein Material zu verwenden, das eine um im wesentlichen 0,1 µm größere Bandkantenwellenlänge als herkömmliche Materialien aufweisen, die auf InP aufgebracht sind. Es ist diese Verschiebung der Bandkantenwellenlänge um 0,1 µm, die den Betrieb der wellenleitenden Schicht 12 bei 1,55 µm anstelle von 1,50 µm ermöglicht.

Für die Schichten 13 und 11 wird vorzugsweise ternäres Material mit der im Vergleich zu InP größeren Gitterkonstanten a verwendet, insbesondere InAsP, das im Vergleich zu einer Bandkantenwellenlänge von etwa 0,93 µm des binären InP eine Bandkantenwellenlänge von etwa 1,1 µm aufweist.

Die wellenleitende Schicht 12 besteht vorzugsweise aus einem ternären und/oder quaternärem Material mit der im Vergleich zu InP größeren Gitterkonstanten a, insbesondere aus In₁-yGa_{y}As mit einer Bandkantenwellenlänge von im wesentlichen 1,75 µm, was einem Bruchteil y der Ga-Atome in diesem Mischungshalbleiter von etwa 0,4 entspricht. Im Vergleich dazu ist bei herkömmlichen Wellenleitern, bei denen das an die beiden Flachseiten und der wellenleitenden Schicht angrenzende Halbleitermaterial bzw. aus InP und die wellenleitende Schicht ebenfalls aus In₁-yGa_{y}As besteht, y gleich 0,47, was einer Bandkantenwellenlänge dieses Mischungshalbleiters von etwa 1,65 µm entspricht, die um 0,1 µm kleiner als die Bandkantenwellenlänge 1,75 µm des erfindungsgemäßen Mischungshalbleiters ist.

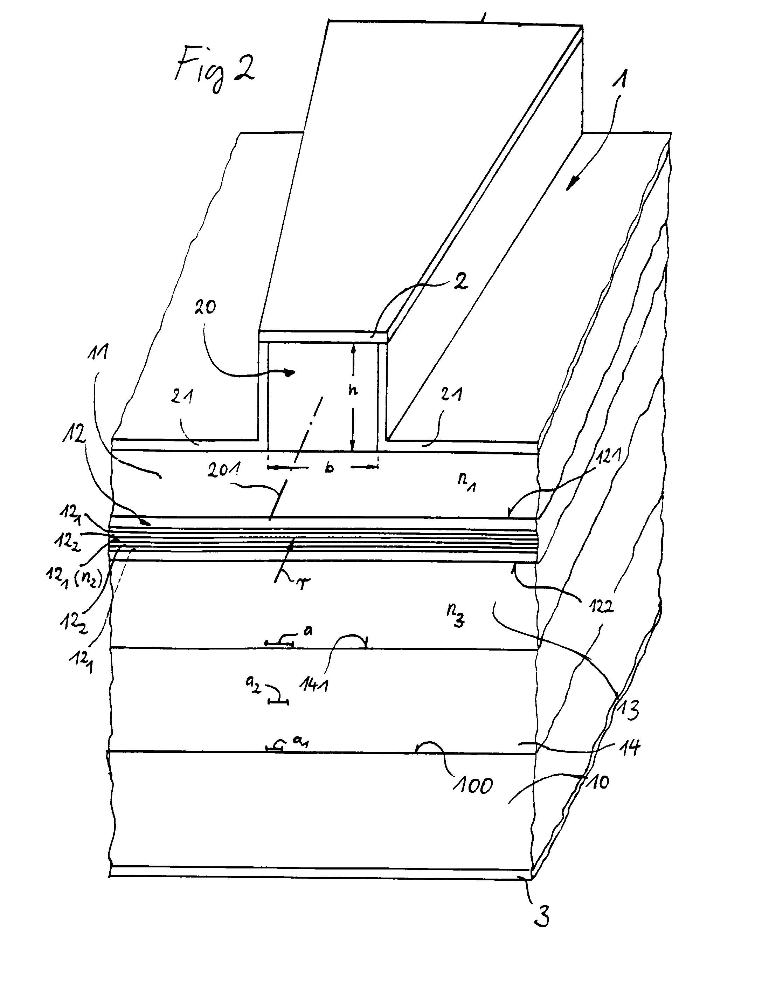

Vorzugsweise weist die wellenleitende Schicht 12 zumindest eine zugverspannte Quantumwell-Schicht 12₁ auf. Dabei kann es auch vorteilhaft sein, wenn die wellenleitende Schicht 12 auch eine druckverspannte Quantumwell-Schicht 12₂ aufweist, wobei es günstig sein kann, wenn die wellenleitende Schicht 12 abwechselnd mehrere zug- und druckverspannte Quantumwell-Schichten 12₁ und 12₂ aufweist. Nach den Figuren 1 und 2 weist die wellenleitende Schicht 12 beispielsweise und ohne Beschränkung der Allgemeinheit drei zugverspannte Quantumwell-Schichten 12₁ und zwei dazwischenliegenden druckverspannte Quantumwell-Schichten 12₂ auf.

Für eine wellenleitende Schicht 12 mit Quantumwell-Schichten 12₁ und auch 12₂ kann das in dieser Schicht 12 enthaltene Material mit der niedrigsten Bandkantenwellenlänge wiederum ternäres Material, beispielsweise InAsP mit der auf den unverspannten Zustand dieses Materials bezogenen Bandkantenwellenlänge 1,1 µm sein, während das in dieser Schicht enthaltene Material mit der größten Bandkantenwellenlänge wiederum In₁-yGa_{y}As mit der auf den unverspannten Zustand dieses Materials bezogenen Bandkantenwellenlänge von 1,75 µm sein.

Die wellenleitende Schicht 12, insbesondere mit einer oder mehreren Quantumwell-Schichten, läßt sich vorteilhafterweise so dimensionieren, daß die optische Verstärkung unabhängig von einer Polarisation des eingekoppelten Lichts ist.

Das Ausführungsbeispiel nach Figur 2 unterscheidet sich vom Ausführungsbeispiel nach Figur 1 lediglich dadurch, daß sich die Breite b der Rippe 20 entlang ihrer Längsachse 201, vorzugsweise in der Ausbreitungsrichtung r des in der wellenleitenden Schicht 12 geführten Lichts taperförmig verbreitert.

Wie das Beispiel nach Figur 1 kann das Beispiel nach Figur 2 ein polarisationsunabhängiger Halbleiterverstärker mit aktiver wellenleitender Schicht mit polarisationsunabhängiger Verstärkung sein. Da die Rippe 20 beim Beispiel nach Figur 2 taperförmig ist und die Wellenführung nur für schmale Rippen polarisationsunabhängig ist, für breitere Rippen dagegen ähnlich wie bei einem Buried Heterostruktur-Wellenleiter polarisationsunabhängig ist, verhält sich die Ausführungsform nach Figur 2 weitgehend polarisationsunabhängig. Durch Integration einer Mikrooptik, die aus einem passiven Wellenleiter mit Mikrooptik, wie z.B. ein Taper, bestehen kann, kann das optische Feld statt des elliptisch verbreiterten Querschnitts am verbreiterten Ende der Rippe wieder einen kreisförmige Querschnitt erhalten.
Das erfindungsgemäße integriert-optische Element 1 ist für optische Übertragungssysteme, insbesondere als optischer Verstärker geeignet.

## Patentansprüche

1. Integriert-optisches Element (1), bestehend aus einem Substrat (10) aus InP,
- einer wellenleitenden Schicht (12) eines bestimmten komplexen Brechungsindexes und
- zwei je einen reellen Brechungsindex (n₁, n₃) aufweisenden Schichten (11, 13) aus Halbleitermaterial, zwischen denen die wellenleitende Schicht (12) angeordnet ist, die an die wellenleitende Schicht (12) grenzen und von denen sich eine zwischen der wellenleitenden Schicht (12) und dem Substrat (10) befindet, wobei
- der komplexe Brechungsindex der wellenleitenden Schicht (12) durch elektrische Ladungsträger steuerbar ist und einen Realteil (n₂) aufweist, der jeweils größer als der reelle Brechungsindex (n₁, n₂) der beiden an die wellenleitende Schicht (12) angrenzenden Schichten (11, 12) ist, wobei
- in die wellenleitende Schicht (12) Licht einer bestimmten Wellenlänge (λ) einkoppelbar und das eingekoppelte Licht im wesentlichen in der wellenleitenden Schicht (12) geführt ist, wobei
- die wellenleitende Schicht (12) eine Kristallgitterkonstante (a) aufweist, die um weniger als ein Prozent größer als eine bestimmte Kristallgitterkonstante (a₁) des InP ist, und wobei
- eine Einrichtung (2,3) zur Steuerung des komplexen Brechungsindexes in der wellenleitenden Schicht (12) vorgesehen ist, so daß die Intensität (I) und/oder Phase (Φ) des in der wellenleitenden Schicht (12) geführten Lichts veränderbar ist,
**dadurch gekennzeichnet**, daß
- die beiden an die wellenleitende Schicht (12) grenzenden Schichten (11, 13) jeweils eine Kristallgitterkonstante (a) aufweisen, die um weniger als ein Prozent größer als die bestimmte Kristallgitterkonstante (a₁) des InP ist, daß
- zwischen dem Substrat (10) und der einen (13) der beiden an die wellenleitende Schicht (12) grenzenden Schichten (11, 13), die sich zwischen der wellenleitenden Schicht (12) und dem Substrat (10) befindet, eine an diese eine Schicht (13) und das Substrat (10) grenzende Trägerschicht (14) aus Halbleitermaterial angeordnet ist, daß
- die Trägerschicht (14) eine Kristallgitterkonstante (a₂) aufweist, die am oder nahe dem Substrat (10) gleich der bestimmten Kristallgitterkonstanten (a₁) des InP ist und vom Substrat (10) in Richtung auf die an die wellenleitende Schicht (12) grenzende eine Schicht (13) auf die größere Kristallgitterkonstante (a) dieser einen Schicht (13) zunimmt, und daß
- die beiden an die wellenleitende Schicht (12) grenzenden Schichten (11, 13) voneinander verschiedenen Leitfähigkeitstyps (p, n) sind.

2. Element nach Anspruch 1,
**dadurch gekennzeichnet**,
daß die Kristallgitterkonstante (a) der wellenleitenden Schicht (12) und jeder der beiden an diese Schicht (12) grenzenden Schichten (11, 13) um im wesentlichen 0,5 Prozent größer als die bestimmte Kristallgitterkonstante (a₁) des InP ist.

3. Element nach Anspruch 1 oder 2,
**dadurch gekennzeichnet**,
daß eine an die wellenleitende Schicht (12) grenzende Schicht (11, 13) aus einem ternären Material besteht.

4. Element nach Anspruch 3,
**dadurch gekennzeichnet,**
daß das ternäre Material aus InAsP besteht.

5. Element nach Anspruch 3 oder 4,
**dadurch gekennzeichnet**,
daß die wellenleitende Schicht (12) aus einem ternären und/oder quaternären Material besteht.

6. Element nach Anspruch 4,
**dadurch gekennzeichnet,**
daß die wellenleitende Schicht (12) aus In_{1-y}Ga_{y}As besteht, wobei y im wesentlichen gleich 0,4 gewählt ist.

7. Element nach einem der Ansprüche 4 bis 6,
**dadurch gekennzeichnet,**
daß die Trägerschicht (14) aus InAsP und InP besteht, wobei die Zusammensetzung vom Substrat (10) in Richtung zur Trägerschicht (14) vom binären InP in das ternäre InAsP übergeht.

8. Element nach Anspruch 7,
**dadurch gekennzeichnet**,
daß der Gehalt des InP von 100% am Substrat (10) graduell in Richtung zur Trägerschicht (14) auf 0% an der Trägerschicht (14) abnimmt und der Gehalt des InAsP von 0% am Substrat (10) graduell in Richtung zur Trägerschicht (14) auf 100% an der Trägerschicht (14) zunimmt

9. Element nach einem der vorhergehenden Ansprüche,
**dadurch gekennzeichne**t,
daß die wellenleitende Schicht (12) zumindest eine zugverspannte Quantumwell-Schicht (12₁) aufweist.

10. Element nach Anspruch 9,
**dadurch gekennzeichnet,**
daß die wellenleitende Schicht (12) zumindest eine druckverspannte Quantumwell-Schicht (12₂) aufweist.

11. Element nach Anspruch 9 und 10,
**dadurch gekennzeichnet**,
daß die wellenleitende Schicht (12) abwechselnd zug- und druckverspannte Quantumwell-Schichten (12₁, 12₂) aufweist.

12. Element nach einem der Ansprüche 5 bis 10,
**dadurch gekennzeichnet,** daß
- auf einer Flachseite (121) der wellenleitenden Schicht (12) eine Rippe (20) mit einer zu dieser Flachseite (121) parallelen und eine Ausbreitungsrichtung (r) des in der wellenleitenden Schicht (12) geführten Lichts bestimmenden Längsachse (201) und einer eine seitlich begrenzte Wellenführung in der wellenleitenden Schicht (12) bewirkenden Breite (b) aufweist,
- die wellenleitende Schicht (12) so dimensioniert ist, daß die durch elektrische Ladungsträger erzeugte Veränderung der Intensität (I) und/oder Phase (Φ) des in dieser Schicht (12) geführten Lichts derart anisotrop ist, daß sie senkrecht zu den Flachseiten (121, 122) größer als parallel zu diesen und senkrecht zur bestimmten Ausbreitungsrichtung(r) ist, und
- die Rippe (20) in bezug auf die wellenleitende Schicht (12) derart dimensioniert ist, daß die von dieser Rippe (20) bewirkte Wellenführung des geführten Lichts derart anisotrop ist, daß sie parallel zu den Flachseiten (121, 122) und senkrecht zur bestimmten Ausbreitungsrichtung(r) stärker als senkrecht zu den Flachseiten (121, 122) ist.

13. Element nach einem der vorhergehenden Ansprüche, insbesondere nach einem der Ansprüche 8 bis 12,
**dadurch gekennzeichnet**,
daß die wellenleitende Schicht (12) so dimensioniert ist, daß die optische Verstärkung unabhängig von einer Polarisation des eingekoppelten Lichts ist.

14. Element nach Anspruch 12 und 13,
**dadurch gekennzeichnet**,
daß sich die Rippe (20) entlang der Längsachse (201) taper-förmig verbreitert.

## Claims

1. Integrated optical element (1) comprising a substrate (10) made of InP
- a wave-guiding layer (12) with a specific complex refraction index and
- two layers (11, 13) which each have a real refraction index (n₁, n₃) and are made of semiconductor material, between which layers (11, 13) the wave-guiding layer (12) is arranged and which layers (11, 13) adjoin the wave-guiding layer (12) and one of which is located between the wave-guiding layer (12) and the substrate (10),
- the complex refraction index of the wave-guiding layer (12) can be controlled by means of electrical charge carriers and has a real component (n₂) which is respectively greater than the real refraction index (n₁, n₂) of the two layers (11, 12) adjoining the wave-guiding layer (12),
- light with a specific wave length (λ) can be injected into the wave-guiding layer (12), and the injected light is guided essentially in the wave-guiding layer (12),
- the wave-guiding layer (12) having a crystal lattice constant (a) which is less than one per cent greater than a specific crystal lattice constant (a₁) of the InP, and
- a device (2, 3) for controlling the complex refraction index being provided in the wave-guiding layer (12) so that the intensity (I) and/or phase (Φ) of the light guided in the wave-guiding layer (12) can be changed,
characterized in that
- the two layers (11, 13) which adjoin the wave-guiding layer (12) each have a crystal lattice constant (a) which is less than one per cent greater than the specific crystal lattice constant (a₁) of the InP, in that
- arranged between the substrate (10) and the one (13) of the two layers (11, 13) adjoining the wave-guiding layer (12) which is located between the wave-guiding layer (12) and the substrate (10) is a carrier layer (14) which adjoins this one layer (13) and the substrate (10) and is made of semiconductor material, in that
- the carrier layer (14) has a crystal lattice constant (a₂) which is equal, at or near to the substrate (10), to the specific crystal lattice constants (a₁) of the InP and increases from the substrate (10) in the direction of the one layer (13) adjoining the wave-guiding layer (12) to the greater crystal lattice constant (a) of this one layer (13), and in that
- the two layers (11, 13) adjoining the wave-guiding layer (12) are of different conductivity types (p, n).

2. Element according to Claim 1, characterized in that the crystal lattice constant (a) of the wave-guiding layer (12) and each of the two layers (11, 13) which are adjacent to this layer (12) is essentially 0.5 per cent higher than the determined crystal lattice constant (a₁) of InP.

3. Element according to Claim 1 or 2, characterized in that a layer (11, 13) which is adjacent to the wave-guiding layer (12) is composed of a ternary material.

4. Element according to Claim 3, characterized in that the ternary material is composed of InAsP.

5. Element according to Claim 3 or 4, characterized in that the wave-guiding layer (12) is composed of a ternary and/or quaternary material.

6. Element according to Claim 4, characterized in that the wave-guiding layer (12) is composed of In_{1-y}Ga_{y}As, y being selected so as to be essentially equal to 0.4.

7. Element according to one of Claims 4 to 6, characterized in that the carrier layer (14) is composed of InAsP and InP, the composition of the substrate (10) in the direction of the carrier layer (14) changing from the binary InP to the ternary InAsP.

8. Element according to Claim 7, characterized in that the content of the InP gradually decreases from 100% at the substrate (10) in the direction of the carrier layer (14) to 0% at the carrier layer (14), and the content of the InAsP gradually increases from 0% at the substrate (10) in the direction of the carrier layer (14) to 100% at the carrier layer (14).

9. Element according to one of the preceding claims, characterized in that the wave-guiding layer (12) has at least one tensile-strained quantum well layer (12₁).

10. Element according to Claim 9, characterized in that the wave-guiding layer (12) has at least one compression-strained quantum well layer (12₂).

11. Element according to Claim 9 and 10, characterized in that the wave-guiding layer (12) has alternately tensile-strained and compression-strained quantum well layers (12₁, 12₂).

12. Element according to one of Claims 5 to 10, characterized in that
- [lacuna] has, on one flat side (121) of the wave-guiding layer (12), a rib (20) with a longitudinal axis (201) which is parallel to this flat side (121) and determines a propagation direction (r) of the light guided in the wave-guiding layer (12) and with a width (b) which brings about a laterally limited waveguidance in the wave-guiding layer (12),
- the wave-guiding layer (12) being dimensioned such that the change, produced by electrical charge carriers, in the intensity (I) and/or phase (Φ) of the light guided in this layer (12) is anisotropic such that said change is greater perpendicular to the flat sides (121, 122) than parallel thereto and is perpendicular to the specific propagation direction (r), and
- the rib (20) is dimensioned with respect to the wave-guiding layer (12) in such a way that the waveguidance, brought about by this rib (20), of the guided light is anisotropic such that said guidance is stronger parallel to the flat sides (121, 122) and perpendicular to the specific propagation direction (r) than perpendicular to the flat sides (121, 122).

13. Device according to one of the preceding claims, in particular according to one of Claims 8 to 12, characterized in that the wave-guiding layer (12) is dimensioned such that the optical amplification is independent of a polarization of the injected light.

14. Element according to Claim 12 and 13, characterized in that the rib (20) widens in a tapered shape along the longitudinal axis (201).

## Revendications

1. Élément optique intégré (1), constitué d'un substrat (10) en InP,
- d'une couche guide d'ondes (12) d'un indice de réfraction complexe déterminé et
- de deux couches (11, 13) en matériau semi-conducteur présentant chacune un indice de réfraction réel (n₁, n₃), entre lesquelles la couche guide d'ondes (12) est disposée, contiguës à la couche guide d'ondes (12) et dont l'une d'elle se trouve entre la couche guide d'ondes (12) et le substrat (10),
- l'indice de réfraction complexe de la couche guide d'ondes (12) étant régulable par des porteurs de charge électriques et présentant une partie réelle (n₂), respectivement supérieure à l'indice de réfraction réel (n₁, n₂) des deux couches (11, 12) contiguës à la couche guide d'ondes (12),
- de la lumière d'une longueur d'onde déterminée (χ) pouvant être alimentée dans la couche guide d'ondes (12) et la lumière alimentée étant guidée substantiellement dans la couche guide d'ondes (12),
- la couche guide d'ondes (12) présentant une constante de réseau cristallin (a), supérieure de moins de 1 % à une constante de réseau cristallin déterminée (a₁) de l'InP, et
- un dispositif (2, 3) étant prévu pour la régulation de l'indice de réfraction complexe dans la couche guide d'ondes (12), si bien que l'intensité (I) et/ou la phase (φ) de la lumière guidée dans la couche guide d'ondes (12) est variable,
**caractérisé en ce que**
- les deux couches (11, 13) contigües à la couche guide d'ondes (12) présentent chacune une constante de réseau cristallin (a), supérieure de moins de 1 % à la constante de réseau cristallin déterminée (a₁) de l'InP, en ce que
- entre le substrat (10) et l'une (13) des deux couches (11, 13) contigües à la couche guide d'ondes (12), qui se trouve entre la couche guide d'ondes (12) et le substrat (10), est disposée une couche-support (14) en matériau semi-conducteur, contigüe à cette couche (13) et au substrat (10), en ce que
- la couche-support (14) présente une constante de réseau cristallin (a2), égale à la constante de réseau cristallin déterminée (a₁) de l'InP sur le ou à proximité du substrat (10) et qui augmente en partant du substrat (10) en direction de la couche (13) contigüe à la couche guide d'ondes (12) vers la constante de réseau cristallin plus grande (a) de cette couche (13), et en ce que
- les deux couches (11, 13) contigües à la couche guide d'ondes (12) sont d'un type de conductibilité différent l'un de l'autre (p, n).

2. Élément selon la revendication 1, caractérisé en ce que la constante de réseau cristallin (a) de la couche guide d'ondes (12) et chacune des deux couches (11, 13) contigües à cette couche (12) est supérieure substantiellement de 0,5 pour cent à la constante de réseau cristallin déterminée (a₁) de l'InP.

3. Élément selon la revendication 1 ou 2, caractérisé en ce que l'une des couches (11, 13) contigües à la couche guide d'ondes (12) est constituée d'un matériau ternaire.

4. Élément selon la revendication 3, caractérisé en ce que le matériau ternaire est constitué d'lnAsP.

5. Élément selon la revendication 3 ou 4, caractérisé en ce que la couche guide d'ondes (12) est constituée d'un matériau ternaire et/ou quaternaire.

6. Élément selon la revendication 4, caractérisé en ce que la couche guide d'ondes (12) est constituée de In₁-_{y}Ga_{y}As, y étant choisi substantiellement égal à 0,4.

7. Élément selon l'une des revendications 4 à 6, caractérisé en ce que la couche-support (14) est constituée d'lnAsP et d'lnP, la composition du substrat (10) en direction de la couche-support (14) passant de l'InP binaire à l'InAsP ternaire.

8. Élément selon la revendication 7, caractérisé en ce que la teneur de l'InP diminue graduellement de 100 % sur le substrat (10) en direction de la couche-support (14) à 0 % sur la couche-support (14) et en ce que la teneur de l'InAsP de 0 % sur le substrat (10) augmente graduellement en direction de la couche-support (14) à 100 % sur la couche-support (14).

9. Élément selon l'une des revendications précédentes, caractérisé en ce que la couche guide d'ondes (12) présente au moins une couché à cuvettes quantiques (12₁) soumise à une contrainte de traction.

10. Élément selon la revendication 9, caractérisé en ce que la couche guide d'ondes (12) présente au moins une couche à cuvettes quantiques (122) soumise à une contrainte de compression.

11. Élément selon les revendications 9 et 10, caractérisé en ce que la couche guide d'ondes (12) présente des couches à cuvettes quantiques (12₁, 12₂) soumises alternativement à des contraintes de traction et de compression.

12. Élément selon l'une des revendications 5 à 10, caractérisé en ce que sur une face plate (121) de la couche guide d'ondes (12) est prévue une nervure (20) avec un axe longitudinal (201) parallèle à cette face plate (121) et déterminant un sens de propagation (r) de la lumière guidée dans la couche guide d'ondes (12) et une largeur (b) causant un guidage d'ondes limité latéralement dans la couche guide d'ondes (12),
- la couche guide d'ondes (12) est dimensionnée de telle sorte que la modification induite par des porteurs de charge électriques de l'intensité (I) et/ou de la phase (φ) de la lumière guidée dans cette couche (12) présente une telle anisotropie que perpendiculairement aux faces plates (121, 122), elle est plus grande que parallèlement à celles-ci et perpendiculairement à une direction de propagation déterminée (r), et en ce que
- la nervure (20) en rapport avec la couche guide d'ondes (12) est dimensionnée de telle sorte que le guidage d'ondes causé par cette nervure (20) de la lumière guidée présente une telle anisotropie que parallèlement aux faces plates (121, 122) et perpendiculairement à la direction de propagation déterminée (r), elle est plus grande que perpendiculairement aux faces plates (121, 122).

13. Élément selon l'une des revendications précédentes, notamment selon l'une des revendications 8 à 12, caractérisé ence que la couche guide d'ondes (12) est dimensionnée de telle sorte que l'amplification optique est indépendante d'une polarisation de la lumière alimentée.

14. Élément selon les revendications 12 et 13, caractérisé en ce que la nervure (20) le long de l'axe longitudinal (201) s'élargit en forme de cône.
